# EUROPÄISCHE PATENTANMELDUNG

(11) **EP 0 905 910 A2**
(43) Veröffentlichungstag der Anmeldung: **31.03.1999**
(21) Anmeldenummer: 98117797.5
(22) Anmeldetag: 18.09.1998
(51) Int. Cl.: H03L 7/183

(54) **Verfahren und Vorrichtung zum Frequenzwechsel in einem mehrkanaligen Funksystem**

(30) Priorität: 25.09.1997 DE 19742390
(71) Anmelder: SIEMENS AKTIENGESELLSCHAFT, 80333 München (DE)
(72) Erfinder: von Pieverling, Klaus, Dr., 82515 Wolfratshausen (DE)

(57) **Zusammenfassung**

Beim Frequenzwechsel in mehrkanaligen Funksystemen werden spannungsgesteuerte Oszillatoren (3) durch Phasenregelkreise (2) stabilisiert. Die Hochfrequenz (HF) wird digital heruntergeteilt und mit einer festen, stabilen Referenzfrequenz (FR) verglichen, die gleich dem Kanalabstand ist. Dadurch ergeben sich bei kleinen Kanalabständen lange Regelungseinschwingzeiten, die zu hohem Stromverbrauch führen.

Durch eine über einige Kanäle variierte Referenzfrequenz (FR) werden höhere Referenzfrequenzen (FR) und damit geringere Regelungseinschwingzeiten und geringerer Stromverbrauch erzielt. Außerdem wird eine Temperaturkompensation und ein Ausgleich von Schaltungstoleranzen erreicht.

Autarke Sende- und Empfangseinrichtungen in Meldesensoren von Funk-Gefahrenmeldeanlagen

## Beschreibung

Die Erfindung bezieht sich auf ein Verfahren und eine Vorrichtung zum Frequenzwechsel in einem mehrkanaligen Funksystem gemäß dem Oberbegriff des Patentanspruchs 1.

Funk-Gefahrenmeldeanlagen umfassen Meldesensoren, die im Fall einer detektierten Gefahr (Brand, Einbruch) eine Gefahrenmeldung über eine Funkverbindung an eine Gefahrenmeldezentrale übermitteln, in der zur Beseitigung der Gefahr weitere Maßnahmen ( Alarmierung der Feuerwehr bzw. der Polizei) eingeleitet werden. Die Meldesensoren umfassen dabei eine Sende-und Empfangseinrichtung und sollen für einen Einsatz an unzulänglichen Orten möglichst autark, d.h. mit einer Batterie und nicht durch einen Kabelanschluß an einem Stromnetz betrieben werden. Dafür sind alle Komponenten des Meldesensors möglichst stromsparend auszulegen, und die Komponenten sollten auch nur zu bestimmten Zeiten eingeschaltet werden und nicht ständig im Betrieb sein.

Bei der herkömmlichen Methode, Signale mit unterschiedlichen Frequenzen für die übertragung zwischen Gefahrenmeldezentrale und Meldesensor bereitzustellen, erzeugt ein spannungsgesteuerter Oszillator (VCO) Signale mit einer Hochfrequenz als Trägerfrequenz mit Hilfe eines Phasenregelkreises (PLL). Dabei erzeugt ein Referenzoszillator, beispielsweise ein Quarzoszillator, Signale mit einer sehr stabilen Frequenz. Ein nachgeschalteter Referenzteiler erzeugt daraus digital eine Referenzfrequenz. Dabei stehen die Referenzfrequenz und die Frequenz des Referenzoszillators in einem ganzzahligen Teilungsverhältnis zueinander. Die vom spannungsgesteuerten Oszillator erzeugte Hochfrequenz wird durch einen Hochfrequenzteiler digital auf eine reduzierte Frequenz heruntergeteilt. Die Hochfrequenz und die reduzierte Frequenz stehen dabei ebenfalls in einem ganzzahligen Teilungsverhältnis zueinander. In einem Phasendetektor wird die Referenzfrequenz mit der reduzierten Frequenz verglichen, und es wird in Abhängigkeit der Abweichung der Frequenzen voneinander eine Fehlerspannung erzeugt. Diese Fehlerspannung wird über ein sogenanntes Schleifenfilter zur Wechselspannungsunterdrückung an den spannungsgesteuerten Oszillator gelegt, der dadurch seine Hochfrequenz ändert. Diese Änderung bewirkt bei feststehendem Teilungsverhältnisses des Hochfrequenzteilers eine Änderung der reduzierten Frequenz, wodurch sich die Fehlerspannung verringert, bis die Referenzfrequenz und die heruntergeteilte Frequenz gleich sind und dann auch die gewünschte Hochfrequenz vom spannungsgesteuerten Oszillator erzeugt wird. Der Phasenregelkreis ist "eingerastet". Eine Änderung der Hochfrequenz erfolgt nun durch eine Änderung des Teilungsverhältnisses des Hochfrequenzteilers. Eine Änderung des Teilungsverhältnisses des Hochfrequenzteilers um Eins bewirkt eine Verschiebung der Hochfrequenz um die Referenzfrequenz. Daher wird bei herkömmmlichen Verfahren zum Erzeugen von unterschiedlichen Hochfrequenzen mit einem vorgegebenen Kanalabstand die Referenzfrequenz gleich dem Kanalabstand gewählt. Völlig analog zu Trägerfrequenzen werden Überlagerungsfrequenzen zum Einsatz in Überlagerungsempfängern generiert. Bei kombinierten Sende- und Empfangseinrichtungen (Transceivern) werden dabei kostensparend einige Komponenten sowohl zum Generieren der Sendesignale wie auch zum Empfangen der ausgesandten Signale verwendet.

Nachteilig bei diesem Verfahren ist die Größe der Regelungseinschwingzeit bei kleinem Kanalabstand. So bedeutet ein Kanalabstand von 25 KHz, wie er beispielsweise für FunkGefahrenmeldeanlagen vorgesehen ist, die bei Hochfrequenzen um 869 MHz arbeiten, daß nur alle 40 µs ein neuer Regelwert zur Verfügung steht. Bei schätzungsweise 100 notwendigen Regelwerten zur korrekten Frequenzeinstellung beträgt damit die Einschwingzeit 4 ms. Im Zusammenhang mit der Anwendung als batteriebetriebener Funkbrandmelder stört der in dieser Zeit fließende Betriebsstrom. Ein weiterer Nachteil der niedrigen Referenzfrequenz besteht darin, daß höherfrequente Instabilitäten des spannungsgesteuerten Oszillators nur ungenügend ausgeregelt werden, wodurch im Spektrum der Hochfrequenz ein unerwünscht hoher Rauschsockel entsteht.

Aus einer Anwendungsnotiz (Philips Semiconductors SA8025 Fractional-N synthesizer for 2GHz band applications AN 1891 von W.S. Djen) ist ein Verfahren bekannt, um die Einschwingzeit und den Rauschsockel zu reduzieren. Dabei wird die Hochfrequenzen nicht durch eine ganze Zahl geteilt und dann mit der Referenzfrequenz im Phasendetektor verglichen, sondern es erfolgt auch ein Teilen durch eine rationale Zahl. Dabei entstehen in nachteiliger Weise unerwünschte Störfrequenzen.

Es ist daher die Aufgabe der Erfindung, ein Verfahren und eine Vorrichtung mit guten Rauscheigenschaften zum Stromsparenden Wechseln der Frequenz in einem mehrkanaligen Funksystem mit einem kleinem Kanalabstand anzugeben.

Die Aufgabe wird erfindungsgemäß durch ein Verfahren der eingangs genannten Art mit den kennzeichnenden Merkmalen des Patentanspruches 1 gelöst.

Erfindungsgemäß wird die störende niedrige Referenzfrequenz dadurch vermieden, daß die Frequenz des Referenzoszillators leicht variiert wird, wenn die Hochfrequenz über einige Kanäle verändert wird. Dadurch ergeben sich höhere Referenzfrequenzen mit der vorteilhaften Folge von niedrigeren Einschwingzeiten und niedrigerem Stromverbrauch beim Senden nach Patentanspruch 1 und beim Empfangen nach dem Überlagerungsprinzip nach Patentanspruch 2.

In einer vorteilhaften Ausgestaltung des Verfahrens nach Patentanspruch 3 wird die Frequenz des Referenzoszillators zusätzlich so variiert, daß eine temperaturabhängige Frequenzabweichung des Referenzoszillators ausgeglichen wird.

Eine weitere vorteilhafte Ausgestaltung des Verfahrens nach Anspruch 4 sieht vor, daß die Frequenz des Referenzoszillators auch unter Berücksichtigung vorhandener Schaltungstoleranzen des Referenzoszillators variiert wird.

Bei einer Ausgestaltung der Erfindung nach Patentanspruch 5 werden beide Überlagerungsfrequenzen eines Empfängers nach dem Doppelsuperprinzip durch die veränderliche Referenzfrequenz erzeugt. Durch die Verwendung nur eines Referenzoszillators werden dabei in vorteilhafter Weise Kosten gespart.

Mittels der gezielten Erzeugung der Überlagerungsfrequenzen nach Patentanspruch 6 wird in vorteilhafter Weise sichergestellt, daß für alle Kanäle beim Empfang mit dem gleichen Bandfilter gearbeitet wird.

Besonders geeignet ist das Verfahren für den Trägerfrequenzbereich zwischen 868 und 870 MHz nach Anspruch 7.

In Anspruch 8 ist in vorteilhafter Weise eine erfindungsgemäße Vorrichtung zur Anwendung des Verfahrens in einem Sender und in Anspruch 9 eine Vorrichtung zur Anwendung in einem Empfänger beschrieben.

In Anspruch 10 ist eine Vorrichtung beschrieben, mit der das erfindungsgemäße Verfahren in einem Transceiver eingesetzt wird.

Die in Anspruch 11 beschriebene Vorrichtung besitzt den Vorteil, daß für beide Überlagerungsfrequenzen eines Empfängers nach dem Doppelsuperprinzip nur ein Referenzoszillator benötigt wird.

In der Ausführung nach Patentanspruch 12 ist eine einfach zu realisierende Frequenzveränderungsvorrichtung vorgesehen.

Die Vorrichtung nach Anspruch 13 umfaßt in vorteilhafter Weise eine Temperaturmeßeinrichtung, um gegebenenfalls einen temperaturabhängigen Abgleich der Frequenz des Referenzoszillators durchzuführen.

Besonders vorteilhaft wird die Vorrichtung im Trägerfrequenzbereich von 868 bis 870 MHz nach Anspruch 14 eingesetzt.

Anhand eines Ausführungsbeispiel wird die Erfindung mit den Figuren der Zeichnung näher erläutert. Dabei zeigen
Fig.1: ein schematisches Blockdiagramm einer erfindungsgemäßen Vorrichtung zum Frequenzwechsel,
Fig.2: ein schematisches Blockdiagramm einer erfindungsgemäßen Sende-Empfangsvorrichtung,
Fig.3: ein schematisches Blockdiagramm zum Frequenzwechsel von zwei unterschiedlichen Überlagerungsfrequenzen.

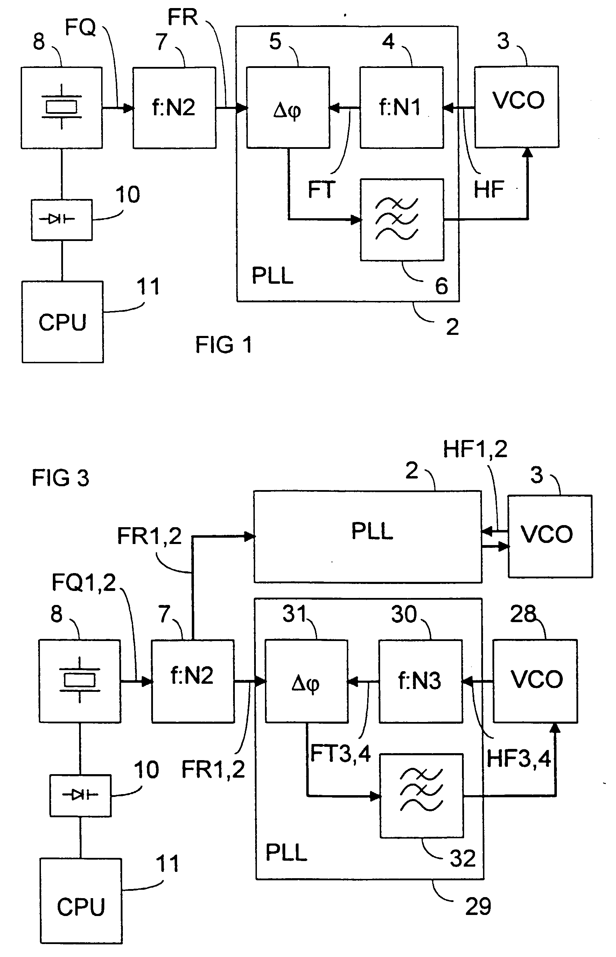

In Fig.1 ist ein erster spannungsgesteuerter Oszillator (VCO) 3 dargestellt, der mit einer ersten Hochfrequenz HF1 schwingt, die durch einen ersten Phasenregelkreis 2 stabilisiert wird. Die erste Hochfrequenz HF1 ist dabei an den Eingang eines ersten Hochfrequenzteilers 4 gelegt und wird durch den ersten Hochfrequenzteiler 4 digital auf eine erste reduzierte Frequenz FT1 heruntergeteilt, wobei die erste Hochfrequenz HF1 und die erste reduzierte Frequenz FT1 in einem ersten festen Teilungsverhältnis N1 zueinander stehen, welches durch den ersten Hochfrequenzteiler 4 eingestellt wird. Die erste reduzierte Frequenz FT1 liegt an einem ersten Eingang eines ersten Phasendetektors 5. In diesem ersten Phasendetektor 5 wird die erste reduzierte Frequenz FT1 mit einer ersten Referenzfrequenz FR1 verglichen. Die erste Referenzfrequenz FR1 entsteht digital durch einen Referenzteiler 8 aus der ersten Frequenz FQ1 eines Referenzoszillator 7 (beispielsweise eines Quarzoszillator). Dabei stehen die erste Referenzfrequenz FR1 und die erste Frequenz FQ1 des Referenzoszillators 7 in einem zweiten ganzzahligen Teilungsverhältnis N2 zueinander, das durch den Referenzteiler 8 vorgegeben ist. Weichen die erste Referenzfrequenz FR1 und die erste reduzierte Frequenz FT1 voneinander ab, erzeugt der erste Phasendetektor 5 eine Fehlerspannung, die über ein erstes Schleifenfilter 6 zur Unterdrückung von Wechselspannungen an den Eingang des ersten spannungsgesteuerten Oszillators 3 gelegt wird, wodurch die erste Hochfrequenz HF1 des ersten spannungsgesteuerten Oszillators 3 geregelt wird. Stimmt die erste Referenzfrequenz FR1 mit der ersten reduzierten Frequenz FT1 überein, wird dadurch keine Fehlerspannung an den ersten spannungsgesteuerten Oszillator 3 angelegt, und die gewünschte erste Hochfrequenz HF1 wird erzeugt. Ein bekanntes Verfahren zum Wechseln der ersten Hochfrequenz HF1 auf eine zweite Hochfrequenz HF2 besteht darin, das Teilungsverhältnis N1 des ersten Hochfrequenzteilers 4 bei konstanter erster Referenzfrequenz FR1 zu variieren. Bei einer Variation des ersten Teilungsverhältnisses N1 um Eins unterscheiden sich die erste (HF1) und die zweite (HF2) Hochfrequenz um die erste Referenzfrequenz FR1. Daher ist die erste Referenzfrequenz FR1 in diesem Verfahren gleich dem Kanalabstand. Bei einer Funkgefahrenmeldeanlage im 870 MHz-Band mit einem Kanalabstand von 25 kHz steht nur alle 40 µs ein neuer Regelwert zur Verfügung. Bei schätzungsweise 100 notwendigen Regelwerten zur korrekten Frequenzeinstellung beträgt damit die Einschwingzeit 4 ms.

Im erfindungsgemäßen Verfahren ist nun vorgesehen zum Wechseln von einer ersten Hochfrequenz HF1 auf eine zweite Hochfrequenz HF2 mithilfe einer regelbaren Frequenzveränderungsvorrichtung 10, die über einen Steuerprozessor 11 angesteuert wird, die erste Frequenz FQ1 des Referenzoszillators 7 auf eine zweite Frequenz FQ2 des Referenzoszillators zu verändern. In der folgenden Tabelle 1 sind die erzeugten Hochfrequenzen HF, die ersten Teilungsverhältnisse N1 des ersten Hochfrequenzteilers 4, die Frequenzen FQ des Referenzoszillators 7 und die Referenzfrequenzen FR bei einem konstanten zweiten Teilungsverhältnis N2 von 111 angegeben (alle Frequenzen in Khz), wenn die Frequenz FQ des Referenzoszillators 7 für jeweils vier Kanäle variiert wird. In diesem Beispiel schwingt der Referenzoszillator nominell bei 11,135649 MHz.

| Hoch-Frequenz HF in kHz | Teilungsverhältnis N1 des Hochfrequenzteilers | Frequenz FQ des Referenzoszillators in kHz | Referenzfrequenz FR in kHz |
|---|---|---|---|
| 869000 | 8690 | 11100,0000 | 100,0000000 |
| 869025 | 8690 | 11100,31933 | 100,0028769 |
| 869050 | 8690 | 11100,3867 | 100,0057537 |
| 869075 | 8690 | 11100,95800 | 100,0086306 |
| 869100 | 8691 | 11100,0000 | 100,0000000 |
| 869125 | 8691 | 11100,31933 | 100,0028769 |
| 869150 | 8691 | 11100,63867 | 100,0057537 |
| 869175 | 8691 | 11100,95800 | 100,0086306 |
| 869200 | 8692 | 11100,0000 | 100,0000000 |

Bei einer relativen Veränderung der Frequenz FQ des Referenzoszillators 7 um 86 ppm läßt sich eine um den Faktor 4 erhöhte Referenzfrequenz FR zur Einstellung der Hochfrequenzen HF bei 869 MHz und einem Kanalabstand vom 25 kHz bewerkstelligen. Dadurch reduziert sich die Einschwingzeit auf 1ms, wodurch der während der Einschwingzeit fließende Strom um den Faktor Vier reduziert wird.

Die beschriebene Maßnahme muß praktisch mit großer Behutsamkeit realisiert werden. Denn durch sie geht zunächst das Wesen der Frequenzsynthetisierung verloren, nämlich die digitale Anbindung der gewünschten, zu erzeugenden Hochfrequenz HF an eine möglichst konstante Referenzfrequenz FR. Die Variation der Frequenz FQ des Referenzoszillators 7 wird schaltungstechnisch beispielsweise durch eine spannungsgesteuerte Kapazitätsdiode (Varaktor) als Frequenzveränderungsvorrichtung 10 erzeugt, deren Steuerspannung durch einen DA-Wandler über den Steuerprozessor 11 eingestellt wird. Dabei ist natürlich darauf zu achten, daß diese Variation stabil in reproduzierbarer Weise erfolgt, damit die hohe Stabilität des Referenzoszillators 7 nicht beeinträchtigt wird. Aus diesem Grund beschränkt sich auch das obige Beispiel auf eine Variation der Hochfrequenz HF über vier Kanäle und damit einer auf 86 ppm beschränkten notwendigen Variation der Frequenz FQ des Referenzoszillators. Dieser Ziehbereich läßt sich bei Grundwellenquarzen als Referenzoszillator 7 ohne nennenswerten Stabilitätsverlust realisieren.

Die mit dem Verfahren erzeugten Hochfrequenzen eignen sich sowohl als Trägerfrequenz für einen Sender als auch als Überlagerungsfrequenzen für einen Empfänger nach dem Überlagerungsprinzip.

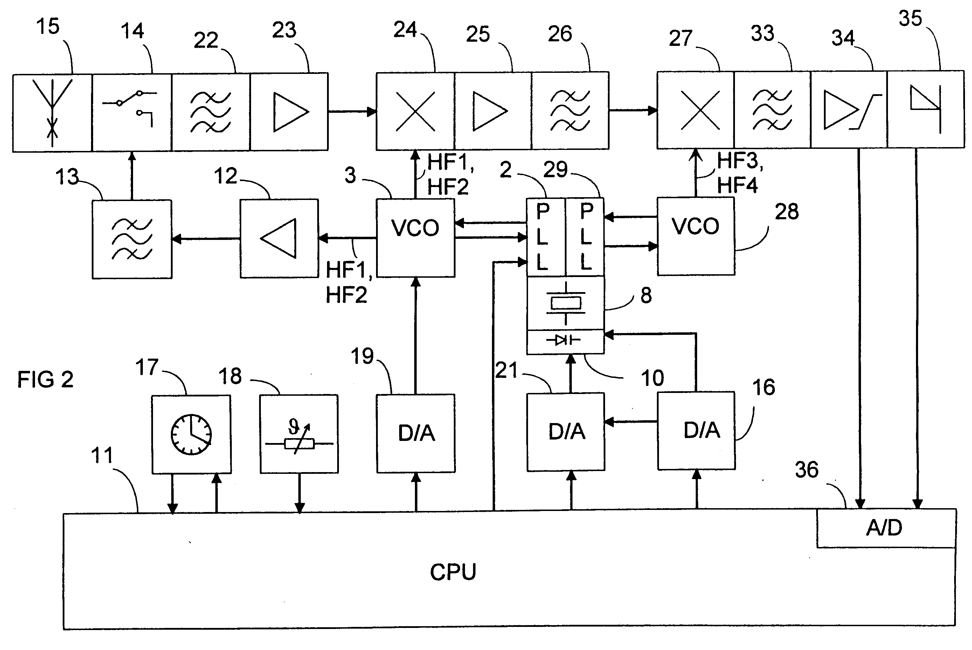

In Fig.2 ist schematisch ein kombinierter Sende-Empfänger (Transceiver) dargestellt, der als batteriebetriebener Sende-Empfänger in Funk-Gefahrenmeldeanlagen eingesetzt wird.

Beim Senden wird dabei mit einem ersten spannungsgesteuerten Oszillator 3 die erste Hochfrequenz HF 1 als erste Trägerfrequenz erzeugt und mit einem ersten Phasenregelkreis 2 stabilisiert. Die gewünschte erste Trägerfrequenz wird in digitaler Form vom Steuerprozessor 11 an den ersten Phasenregelkreis 2 übertragen. Zur Stabilisierung dient ein Quarzoszillator als Referenzoszillator 8, der über eine Varaktordiode als Frequenzveränderungseinrichtung 10, die über einen Digital-Analogwandler 21 zur Temperaturkompensation und/oder zum Frequenzwechsel mit dem Steuerprozessor 11 verbunden ist. Zur Reduzierung der Einschwingzeit wird über einen Digital-Analog-Wandler 19 zur Kanal-Voreinstellung vom Steuerprozessor 11 eine Voreinstellung des ersten spannungsgesteuerten Oszillators 3 vorgenommen. Die Datenübertragung zum Empfänger erfolgt mit Schmalband-FM-Modulation, realisiert durch eine Frequenzmodulation der Frequenz FQ des Referenzoszillators 8 über einen vom Steuerprozessor 11 betriebenen Digital-Analog-Wandler 16 zur Sende-Modulation. Das Ausgangssignal des ersten spannungsgesteuerten Oszillators 3 wird in einem Sendeverstärker 12 verstärkt und über ein Sendefilter 13 zur Unterdrückung von Oberwellen und einen Sende-Empfangsschalter 14 an eine Antenne 15 zum Senden übertragen.

Beim Betrieb des Transceivers als Empfänger wird der Sende-Empfangsschalter 14 umgeschaltet und das empfangene Signal mit der ersten Trägerfrequenz über ein Eingangsfilter 22 (869 MHz-Oberflächenwellen-Filter zur Unterdrückung von Außerbandstörfrequenzen) zum Vorverstärker 23 geleitet. In einem ersten Mischer 24 wird das empfangene Signal mit einer ersten Überlagerungsfrequenz gemischt, die als erste Hochfrequenz HF1 vom ersten spannungsgesteuerten Oszillator 3 bereitgestellt wird. Die Erzeugung des ersten Überlagerungsfrequenz erfolgt dabei analog zur Erzeugung der Trägerfrequenzen im Sendefall. Der Wechsel von einer ersten Überlagerungsfrequenz für eine erste empfangene Trägerfrequenz auf eine zweite Überlagerungsfrequenz für eine zweite empfangene Trägerfrequenz erfolgt dabei ebenfalls durch Wechsel von der ersten Frequenz FQ1 des Referenzoszillators 8 auf die zweite Frequenz FQ2 des Referenzoszillators 8. Beim Mischen zwischen erster Trägerfrequenz und erster Überlagerungsfrequenz entsteht dabei eine erste Zwischenfrequenz im Bereich von 45 MHz, während beim Mischen von der zweiten Trägerfrequenz mit der zweiten Überlagerungsfrequenz eine zweite Zwischenfrequenz im Bereich von 45 MHz entsteht.

Als erster Mischer kann beispielsweise ein Dual-Gate-Feldeffekttransistor eingesetzt werden, dessen Ausgangssignal mit der ersten oder zweiten Zwischenfrequenz in einem ersten Zwischenfrequenzverstärker 25 verstärkt und in einem ersten Bandfilter 26 gefiltert wird. In einem nachgeschalteten zweiten Mischer 27 wird die erste oder zweite Zwischenfrequenz durch eine dritte Überlagerungsfrequenz eines zweiten spannungsgesteuerten Oszillators 28 auf eine dritte Zwischenfrequenz im Bereich von 455 kHz umgesetzt.

In Fig. 3 ist dargestellt, daß der zweite spannungsgesteuerten Oszillator 28 in einem zweiten Phasenregelkreis 29 auf die dritte Überlagerungsfrequenz als dritte Hochfrequenz HF3 stabilisiert wird. Im zweiten Phasenregelkreis 29 wird die Hochfrequenz durch einen zweiten Hochfrequenzteiler 30 digital auf eine dritte reduzierte Frequenz FT3 heruntergeteilt, die in einem zweiten Phasendetektor 31 mit der ersten Referenzfrequenz FR1 aus dem Referenzteiler 7 verglichen wird, mit der auch der erste Phasenregelkreis 2 den ersten spannungsgesteuerten Oszillator 2 stabilisiert. Die dritte reduzierte Frequenz FT3 steht dabei in einem dritten ganzzahligen Teilungsverhältnis N3 zur dritten Hochfrequenz HF3. In Abhängigkeit von der Differenz zwischen der dritten heruntergeteilten Frequenz FT3 und der ersten Referenzfrequenz FR1 wird über ein zweites Schleifenfilter 32 eine Spannung an den zweiten spannungsgesteuerten Oszillator 28 angelegt bis dieser die gewünschte dritte Hochfrequenz HF3 erzeugt. Bei einem Wechsel von der ersten empfangenen Trägerfrequenz auf die zweite Trägerfrequenz wird, wie bereits geschildert, die erste Referenzfrequenz FR1 auf die zweite Referenzfrequenz FR2 durch die vom Steuerprozessor 11 gesteuerte Frequenzveränderungsvorrichtung 10 geändert. Damit ändert sich bei konstant gehaltenem Teilungsverhältnis N3 auch die dritte Hochfrequenz HF3 des spannungsgesteuerten Oszillators 28 auf eine vierte Hochfrequenz HF4, die einer vierten Überlagerungsfrequenz entspricht. Dadurch verändert sich auch die dritte Zwischenfrequenz in eine vierte Zwischenfrequenz.

In Fig.2 ist dargestellt, daß die dritte oder vierte Zwischenfrequenz anschließend in einem zweiten Bandfilter 33 gefiltert wird. Dieses zweite Bandfilter 33 bestimmt die Trennschärfe des Empfänger und ist daher schmalbandig auszulegen. Das gefilterte Signal wird anschließend in einem Begrenzer 34 begrenzt und in einem FM-Demodulator 35 demoduliert. Der FM-Demodulator 35 liefert ein analoges Empfangsdaten-Basissignal und ein analoges Pegelsignal zur Beurteilung der Empfangsqualität über einen Analog-Digital-Wandler 36 an den Steuerprozessor 11.

Bei herkömmlichen Empfängern nach dem Doppelsuper-Prinzip ohne veränderliche Referenzfrequenz FR werden die erste und die zweite Überlagerungsfrequenz in Abhängigkeit von der ersten und der zweiten Trägerfrequenz so erzeugt, daß die erste Zwischenfrequenz gleich der zweiten Zwischenfrequenz ist. Beispielsweise wird bei einer ersten Trägerfrequenz von 868,300 MHz und einer zweiten Trägerfrequenz von 868,400 MHz die erste Überlagerungsfrequenz gleich 913,300 MHz und die zweite Überlagerungsfrequenz gleich 913,400 MHz erzeugt, um in beiden Fällen eine Zwischenfrequenz von 45 MHz zu erhalten. Bei diesen bekannten Empfängern wird die dritte Überlagerungsfrequenz nicht variiert, sondern beispielsweise gleich 44,545 MHz gewählt, so daß nach dem zweiten Mischer die gemeinsame dritte Zwischenfrequenz, im Beispiel 455 kHz, entsteht.

Bei direkter Anwendung des erfindungsgemäßen Verfahrens mit Stabilisierung des zweiten spannungsgesteuerten Oszillators 28 durch die veränderliche Referenzfrequenz FR würde sich die dritte Überlagerungsfrequenz auf eine vierte Überlagerungsfrequenz so verändern, daß eine vierte Zwischenfrequenz entstehen würde, die außerhalb des Durchlaßbereichs des schmalbandigen zweiten Bandfilters 33 liegen könnte. Beispielsweise würde eine Differenz von 100 kHz zwischen erster und zweiter Überlagerungsfrequenz im 913 MHz-Bereich eine Differenz von 5 kHz zwischen der dritten und vierten Überlagerungsfrequenz im 45 MHz-Bereich hervorrufen, da die relativen Veränderungen (Faktor 20) der Überlagerungsfrequenzen durch die veränderliche Referenzfrequenz gleich bleiben. Die dritte Zwischenfrequenz würde sich dadurch beispielsweise von 455 kHz auf die vierte Zwischenfrequenz von 450 kHz verändern. Da der Durchlaßbereich des schmalbandigen zweiten Bandfilters 33 bei 455 ± 3,5 kHz liegt, würde diese vierte Zwischenfrequenz bereits nicht mehr durchgelassen werden.

Erfindungsgemäß wird dieser Effekt dadurch vermieden, daß die erste und die zweite Überlagerungsfrequenz bereits so erzeugt werden (im Beispiel: erste Überlagerungsfrequenz gleich 913,300 MHz, zweite Überlagerungsfrequenz gleich 913,405 MHz), daß die erste Zwischenfrequenz gleich 45,000 MHz und die zweite Zwischenfrequenz gleich 45,005 MHz und damit unterschiedlich sind. Bei der dritten und der vierten Überlagerungsfrequenz aus dem obigen Beispiel würde eine vierte Zwischenfrequenz von 455 kHz und damit gleich der dritten Zwischenfrequenz entstehen. Durch diese zusätzliche Veränderung um 5 kHz zwischen erster und zweiter Überlagerungsfrequenz im 913 MHz-Bereich wird jedoch eine zusätzliche Veränderung in gleicher relativer Höhe (Faktor 20) von ungefähr 250 Hz im 45 MHz-Bereich zwischen der dritten und vierten Überlagerungsfrequenz erzeugt, so daß zwischen dritter und vierter Zwischenfrequenz noch eine Differenz von 250 Hz besteht. Diese Differenz ist allerdings so gering, daß die dritte und die vierte Zwischenfrequenz vom gemeinsamen zweiten schmalbandigen Bandfilter 33 durchgelassen werden. Beim erfindungsgemäßen Verfahren ergeben sich durch die gleiche relative Veränderung von der ersten zu der zweiten Überlagerungsfrequenz und von der dritten zu der vierten Überlagerungsfrequenz unterschiedliche absolute Veränderungen zwischen den Überlagerungsfrequenzen, da die erste und die zweite Überlagerungsfrequenz in einem anderen Frequenzbereich liegen als die dritte und die vierte Überlagerungsfrequenz. Dadurch ist gewährleistet, daß die erste und die zweite Überlagerungsfrequenz so erzeugt werden, daß die dritte und die vierte Zwischenfrequenz nahe genug beieinander liegen, um vom gemeinsamen zweiten Bandfilter 33 gefiltert zu werden.

Da das zweite Bandfilter 33 die Trennschärfe des Empfängers bestimmt und daher schmalbandiger ausgelegt ist als das erste Bandfilter 26, werden die erste und die zweite Überlagerungsfrequenz so erzeugt, daß die dann resultierenden dritte und vierte Zwischenfrequenz möglichst beide in der Mitte des Durchlaßbereiches des zweiten Bandfilters 33 liegen. Damit liegen die erste und die zweite Zwischenfrequenz etwas von der Mitte des Durchlaßbereiches des ersten Bandfilters 26 entfernt. Letzteres stört den Empfang allerdings nicht, da, wie bereits geschildert, die Bandbreite des ersten Bandfilters 26 ausreichend groß gewählt wird.

Durch eine geschickte Realisierung der Referenzfrequenzverschiebung können auch Temperaturgänge oder Schaltungstoleranzen des Referenzoszillators 7 ausgeglichen werden.

Normalerweise durchläuft der Temperaturgang eines Quarzes eine durch den Quarzschnitt gegebene S-Kurve, wobei man die Wahl hat zwischen einem weiten Betriebstemperaturbereich, verbunden mit größerer maximaler Frequenzabweichung und einem kleineren Betriebstemperaturbereich mit kleinerer maximaler Frequenzabweichung. Bei einer Betriebsfrequenz von 869 MHz und 25 KHz Kanalabstand wird an die Stabilität der Referenzfrequenz FR eine hohe Anforderung gestellt. So ist für eine maximale Abweichung von 10% vom Kanalabstand, d.h. von ± 2,5 KHz eine Stabilität von ± 2,7 ppm bei der Referenzfrequenz notwendig. Dieses Problem läßt sich nun bei dem erfindungsgemäßen Verfahren durch eine im Steuerprozessor 11 abgespeicherte Temperaturkompensationstabelle lösen. Dazu wird der Temperaturgang eines Ouarzes als Referenzoszillator 7 einmal repräsentativ zum Aufbau der Kompensationstabelle vermessen. Die Temperatur des Referenzoszillators 7 läßt sich dann im Betrieb mit ausreichender Genauigkeit, zum Beispiel durch die Schwellspannung von Dioden in einer Temperaturmeßeinrichtung 18 messen. Mit Hilfe der abgespeicherten Temperaturkompensationstabelle wird aus den gemessenen Temperaturen ein Wert für die vom Steuerprozessor 11 an die Frequenzveränderungsvorrichtung 10 anzulegende Spannung ermittelt und angelegt, damit die Frequenz FQ des Referenzoszillators wieder auf den gewünschten Wert korrigiert wird.

Bei konventioneller Referenzfrequenzerzeugung ist für die erforderliche Frequenzgenauigkeit ein Trimmvorgang unumgänglich zum Ausgleich der Schaltungstoleranzen eines Quarzoszillators als Referenzoszillator 7, selbst wenn der Schwingquarz als solcher mit extrem enger Liefertoleranz gewählt wird. Dieser Frequenzabgleich läßt sich bei der erfindungsgemäßen Lösung ebenfalls durch die Frequenzveränderungsvorrichtung 10 realisieren. Praktischerweise wird also der aus der Fertigung kommende, mit weit toleriertem Quarz bestückte Referenzoszillator 7 in einem Prüffeld eingeschaltet und innerhalb des Ziehbereiches, beginnend bei der untersten Spannungsgrenze einige Spannungen über den Digital-Analog-Wandler 21 zur Temperaturanpassung und/oder Kanalverstellung angelegt, die resultierende Frequenz FQ des Referenzoszillators 7 gemessen und der Digital-Analog-Wandler-Stellwert sowie die zugeordnete Frequenz FQ des Referenzoszillators 7 gespeichert. Mit einem Frequenzberechnungsprogramm können nun ohne Schwierigkeiten das für jeden Kanal notwendige erste Teilungsverhältnis des Hochfrequenzteilers 7 und die Digital-Analog-Wandlerstellung ermittelt und im Speicher des Steuerprozessors 11 hinterlegt werden. Durch das beschriebene Verfahren und die Vorrichtung werden also nicht nur Einschwingzeiten reduziert und damit der Stromverbrauch vermindert, sondern es ergeben sich auch zusätzliche Möglichkeiten, Temperaturgänge und Spannungstoleranzen auszuregeln.
Eine zeitgesteuerte Überwachungseinrichtung, beispielsweise eine quarzgesteuerte Weckuhr 17 sorgt dafür, daß der Transceiver nur zu vorgegebenen Zeiten eingeschaltet wird, damit der Stromverbrauch minimiert wird.

## Patentansprüche

1. Verfahren zum Frequenzwechsel in einem mehrkanaligen Funksystem mit mindestens einem Sender und mindestens einem Empfänger, wobei in mindestens einem der Sender dessen verschiedene, einzelnen Kanälen zugeordnete, Trägerfrequenzen generiert werden, wobei eine als erste Trägerfrequenz genutzte erste Hochfrequenz (HF1) eines spannungsgesteuerten Oszillators (3) in einem Phasenregelkreis (2) dadurch stabilisiert wird, daß die erste Hochfrequenz (HF1) in einem dem spannungsgesteuerten Oszillator (3) nachgeschalteten Hochfrequenzteiler (4) auf eine erste reduzierte Frequenz (FT1) heruntergeteilt und diese erste reduzierte Frequenz (FT1) in einem Phasendetektor (5) mit einer ersten Referenzfrequenz (FR1) verglichen wird, welche durch einen Referenzteiler (7) aus der ersten Frequenz (FQ1) eines Referenzoszillators (8) erzeugt wird, wobei der Phasendetektor (5) eine Spannung erzeugt, die über ein Schleifenfilter (6) die erste Hochfrequenz (HF1) des spannungsgesteuerten Oszillator (3) stabilisiert, und wobei die erste Hochfrequenz (HF1) und die erste reduzierte Frequenz (FT1) in einem vorgegebenen ersten Teilungsverhältnis (N1) zueinander und die erste Frequenz (FQ1) des Referenzoszillators (8) mit der ersten Referenzfrequenz (FR1) in einem vorgegebenen zweiten Teilungsverhältnis (N2) zueinander stehen,
**dadurch gekennzeichnet,**
daß zumindest für vorgegebene Kanalgruppen die erste Frequenz (FQ1) des Referenzoszillators (8) auf eine zweite Frequenz (FQ2) des Referenzoszillators (8) durch eine von einem Steuerungsprozessor (11) gesteuerte Frequenzveränderungsvorrichtung (10) so verändert wird, daß der Phasenregelkreis (2) bei konstant gehaltenem ersten (N1) und zweiten (N2) Teilungsverhältnis einen Wechsel der ersten Hochfrequenz (HF1) des spannungsgesteuerten Oszillators auf eine zweite Hochfrequenz (HF2) und damit einen Wechsel von der ersten auf eine zweite Trägerfrequenz des Senders bewirkt.

2. Verfahren zum Frequenzwechsel in einem mehrkanaligen Funksystem mit mindestens einem Sender und mindestens einem Empfänger, wobei in mindestens einem der Empfänger als Überlagerungsempfänger dessen verschiedene, den Trägerfrequenzen der einzelnen Kanäle zugeordnete Überlagerungsfrequenzen generiert werden, wobei eine als erste Überlagerungsfrequenz genutzte erste Hochfrequenz (HF1) eines spannungsgesteuerten Oszillators (3) in einem Phasenregelkreis (2) dadurch stabilisiert wird, daß die erste Hochfrequenz (HF1) in einem dem spannungsgesteuerten Oszillator (3) nachgeschalteten Hochfrequenzteiler (4) auf eine erste reduzierte Frequenz (FT1) heruntergeteilt und diese erste reduzierte Frequenz (FT1) in einem Phasendetektor (5) mit einer ersten Referenzfrequenz (FR1) verglichen wird, welche durch einen Referenzteiler (7) aus der ersten Frequenz (FQ1) eines Referenzoszillators (8) erzeugt wird, wobei der Phasendetektor (5) eine Spannung erzeugt, die über ein Schleifenfilter (6) die erste Hochfrequenz (HF1) des spannungsgesteuerten Oszillator (3) stabilisiert, und wobei die erste Hochfrequenz (HF1) und die erste reduzierte Frequenz (FT1) in einem vorgegebenen ersten Teilungsverhältnis (N1) zueinander und die erste Frequenz (FQ1) des Referenzoszillators (8) mit der ersten Referenzfrequenz (FR1) in einem vorgegebenen zweiten Teilungsverhältnis (N2) zueinander stehen,
**dadurch gekennzeichnet,**
daß zumindest für vorgegebene Kanalgruppen die erste Frequenz (FQ1) des Referenzoszillators (8) auf eine zweite Frequenz (FQ2) des Referenzoszillators (8) durch eine von einem Steuerungsprozessor (11) gesteuerte Frequenzveränderungsvorrichtung (10) so verändert wird, daß der Phasenregelkreis (2) bei konstant gehaltenem ersten (N1) und zweiten (N2) Teilungsverhältnis einen Wechsel der ersten Hochfrequenz (HF1) des spannungsgesteuerten Oszillators auf eine zweite Hochfrequenz (HF2) und damit einen Wechsel von der ersten auf eine zweite Überlagerungsfrequenz des Empfängers bewirkt.

3. Verfahren zum Frequenzwechsel nach einem der Ansprüche 1 oder 2,
**dadurch gekennzeichnet,**
daß die temperaturabhängige Frequenzabweichung des Referenzoszillators (8) gemessen und im Steuerprozessor (11) abgespeichert wird,
daß die Temperatur während des Sende- und/oder Empfangsbetriebs gemessen wird,
und daß die vom Steuerprozessor (11) gesteuerte Frequenzveränderungsvorrichtung (10) die Frequenz (FQ) des Referenzoszillators mithilfe der abgespeicherten Werte der temperaturabhängigen Frequenzabweichung auf ihren Sollwert abstimmt.

4. Verfahren zum Frequenzwechsel nach einem der Ansprüche 1, 2 oder 3,
**dadurch gekennzeichnet,**
daß eine durch Schaltungstoleranzen hervorgerufene Abweichung vom Sollwert der Frequenz (FQ) des Referenzoszillators ausgemessen und im Steuerprozessor (10) abgespeichert wird,
und daß die vom Steuerprozessor (11) gesteuerte Frequenzveränderungsvorrichtung (10) die Frequenz (FQ) des Referenzoszillators mit den abgespeicherten Werten der durch Schaltungstoleranzen hervorgerufenen Abweichung auf ihren Sollwert abstimmt.

5. Verfahren zum Frequenzwechsel nach einem der Ansprüche 2 bis 4 bei einem Empfänger nach dem Doppelsuperprinzip, bei dem eine aus der Mischung der ersten Überlagerungsfrequenz mit der ersten Trägerfrequenz entstehende erste Zwischenfrequenz in einem ersten Bandfilter (26) gefiltert und anschließend mit einer dritten Überlagerungsfrequenz gemischt und eine daraus resultierende dritte Zwischenfrequenz in einem zweiten Bandfilter (33) gefiltert wird,
**dadurch gekennzeichnet,**
daß eine als dritte Überlagerungsfrequenz genutzte dritte Hochfrequenz (HF3) eines zweiten spannungsgesteuerten Oszillators (28) in einem zweiten Phasenregelkreis (29) dadurch stabilisiert wird, daß die dritte Hochfrequenz (HF3) in einem dem zweiten spannungsgesteuerten Oszillator (28) nachgeschalteten zweiten Hochfrequenzteiler (30) auf eine dritte reduzierte Frequenz (FT3) heruntergeteilt und diese dritte reduzierte Frequenz (FT3) in einem zweiten Phasendetektor (31) mit der ersten Referenzfrequenz (FR1) verglichen wird, wobei der zweite Phasendetektor (31) eine Spannung erzeugt, die über ein zweites Schleifenfilter (32) die dritte Hochfrequenz (HF3) des zweiten spannungsgesteuerten Oszillator (28) stabilisiert, und wobei die dritte Hochfrequenz (HF3) und die dritte reduzierte Frequenz (FT3) in einem vorgegebenen dritten Teilungsverhältnis (N3) zueinander stehen,
wobei die erste Frequenz (FQ1) des Referenzoszillators (8) auf die zweite Frequenz (FQ2) des Referenzoszillators (8) so verändert wird, daß der zweite Phasenregelkreis (29) bei konstant gehaltenem dritten (N3) und zweiten (N2) Teilungsverhältnis einen Wechsel der dritten Hochfrequenz (HF3) des zweiten spannungsgesteuerten Oszillators (28) auf eine vierte Hochfrequenz (HF4) und damit einen Wechsel von der dritten auf eine vierte Überlagerungsfrequenz des Empfängers bewirkt, so daß anstelle der dritten Zwischenfrequenz eine vierte Zwischenfrequenz entsteht.

6. Verfahren zum Frequenzwechsel nach Anspruch 5,
**dadurch gekennzeichnet,**
die erste und die zweite Überlagerungsfrequenz so erzeugt werden, daß die dritte und die vierte Zwischenfrequenz im mittleren Durchlaßbereich des zweiten Bandfilters (33) liegen.

7. Verfahren zum Frequenzwechsel nach einem der Ansprüche 1 bis 6,
**dadurch gekennzeichnet,**
daß mit Trägerfrequenzen zwischen 868 und 870 MHz gearbeitet wird.

8. Vorrichtung zum Frequenzwechsel in einem mehrkanaligen Funksystem in einem Sender mit einem eine als erste Trägerfrequenz dienende erste Hochfrequenz (HF1) erzeugenden spannungsgesteuerten Oszillator (3), dessen erster Ausgang mit einem Sendeverstärker (12) verbunden ist und dessen zweiter Ausgang in einem ersten Phasenregelkreis (2) über einen ersten Hochfrequenzteiler (4) mit einem ersten Eingang eines ersten Phasendetektors (5) und der Ausgang des ersten Phasendetektors (5) über ein erstes Schleifenfilter (6) mit einem Eingang des ersten spannungsgesteuerten Oszillators (3) verbunden ist, wobei ein zweiter Eingang des ersten Phasendetektors (5) über einen Referenzteiler (7) mit einem Referenzoszillator (8) verbunden ist,
**dadurch gekennzeichnet,**
daß eine dem Referenzoszillators (8) zugeordnete, regelbare Frequenzveränderungsvorrichtung (10) mit einem Steuerprozessor (11) verbunden ist.

9. Vorrichtung zum Frequenzwechsel in einem mehrkanaligen Funksystem in einem Empfänger als Überlagerungsempfänger mit einem eine als erste Überlagerungsfrequenz dienende erste Hochfrequenz (HF1) erzeugenden ersten spannungsgesteuerten Oszillator (3), dessen erster Ausgang mit einem ersten Mischer (24) zur Mischung mit dem empfangenen Signal mit einer ersten Trägerfrequenz verbunden ist und dessen zweiter Ausgang in einem ersten Phasenregelkreis (2) über einen ersten Hochfrequenzteiler (4) mit einem ersten Eingang eines ersten Phasendetektors (5) und der Ausgang des ersten Phasendetektors (5) über ein erstes Schleifenfilter (6) mit einem Eingang des ersten spannungsgesteuerten Oszillators (3) verbunden ist, wobei ein zweiter Eingang des Phasendetektors (5) über einen Referenzteiler (7) mit einem Referenzoszillator (8) verbunden ist,
**dadurch gekennzeichnet,**
daß eine dem Referenzoszillator (8) zugeordnete, regelbare Frequenzveränderungsvorrichtung (10) mit einem Steuerprozessor (11) verbunden ist.

10. Vorrichtung zum Frequenzwechsel nach Anspruch 9,
**dadurch gekennzeichnet,**
daß zwischen einer Antenne (15) und dem ersten Mischer (24) ein Sende- und Empfangsschalter (14) vorgesehen ist, der im Empfangsfall so geschaltet ist, daß ein von der Antenne (15) empfangenes Signal zum ersten Mischer (24) gelangt, und der im Sendefall so geschaltet ist, daß er eine Verbindung zwischen der dann als Sendeantenne dienenden Antenne (15) und einem Sendeverstärker (12) schafft, der mit dem ersten spannungsgesteuerten Oszillator (3) so verbunden ist, daß die vom ersten spannungsgesteuerten Oszillator (3) erzeugte erste Hochfrequenz (HF1) als Trägerfrequenz genutzt wird.

11. Vorrichtung zum Frequenzwechsel nach einem der Ansprüche 9 oder 10,
**dadurch gekennzeichnet,**
daß zum Erzeugen einer zusätzlichen dritten Hochfrequenz (HF3) als dritte Überlagerungsfrequenz ein zweiter Spannungsgesteuerter Oszillator (28) vorgesehen ist, dessen erster Ausgang mit einem zweiten Mischer (27) zur Mischung mit dem aus der aus dem ersten Mischer (24) erzeugten ersten Zwischenfrequenz verbunden ist und dessen zweiter Ausgang in einem zweiten Phasenregelkreis (29) über einen zweiten Hochfrequenzteiler (30) mit einem ersten Eingang eines zweiten Phasendetektors (31) und der Ausgang des zweiten Phasendetektors (31) über ein zweites Schleifenfilter (32) mit einem Eingang des Zweiten spannungsgesteuerten Oszillators (28) verbunden ist, wobei ein zweiter Eingang des zweiten Phasendetektors (31) über den Referenzteiler (7) mit dem Referenzoszillator (8) verbunden ist.

12. Vorrichtung zum Frequenzwechsel nach einem der Ansprüche 8 bis 11,
**gekennzeichnet durch**
eine Varaktordiode als regelbare Frequenzveränderungsvorrichtung (10).

13. Vorrichtung zum Frequenzwechsel nach einem der Ansprüche 8 bis 12,
**gekennzeichnet durch**
eine Temperaturmeßeinrichtung (18), die mit dem Steuerprozessor (11) verbunden ist.

14. Vorrichtung zum Frequenzwechsel nach einem der Ansprüche 8 bis 13,
**gekennzeichnet durch**
Trägerfrequenzen zwischen 868 und 870 MHz.
